# EUROPÄISCHE PATENTANMELDUNG

(11) **EP 4 080 563 A1**
(43) Veröffentlichungstag der Anmeldung: **26.10.2022**
(21) Anmeldenummer: 21169983.0
(22) Anmeldetag: 22.04.2021
(51) Int. Cl.: H01L 23/488, H01L 21/60, H01L 23/367, H01L 23/495, H01L 23/373, H01L 25/07

(54) **AUF EINEN SCHALTUNGSTRÄGER AUFBRINGBARES SCHALTUNGSELEMENT, ELEKTRISCHER VERBINDER SOWIE VERFAHREN ZUM HERSTELLEN EINER ELEKTRISCHEN VERBINDUNG**

(71) Anmelder: Siemens Aktiengesellschaft, 80333 München (DE)
(72) Erfinder: Feil, Wolfgang, 92421 Schwandorf (DE); Kiefl, Stefan, 80992 München (DE); Schaller, Karl-Heinz, 92289 Ursensollen (DE); Stegmeier, Stefan, 81825 München (DE); Wöllmer, Heinz, 92260 Ammerthal (DE)

(57) **Zusammenfassung**

Die vorliegende Erfindung betrifft ein auf einen Schaltungsträger aufbringbares Schaltungselement (20) sowie einen dazu passenden elektrischen Verbinder (30A, 30B) mit besonders geformten elektrischen Kontakten. Erfindungsgemäß weist einer der Kontakte einen flächigen Abschnitt auf, auf dem ein Zapfen (23A, 23B) ausgebildet ist, und der Partnerkontakt weist eine dazu passende Aussparung (32A,32B) auf. Im verbundenen Zustand bildet der Zapfen mit der Aussparung eine kaltgeschweißte Verbindung.

Die vorliegende Erfindung betrifft ferner ein Verfahren zum Herstellen einer elektrischen Verbindung zwischen einem auf einem Schaltungsträger anbringbaren Schaltungselement und einem weiteren Element, die über Kontakte wie vorstehend beschrieben verfügen, wobei das leitfähige Material des Zapfens und das leitfähige Material der Aussparung so gewählt werden, dass diese kaltverschweißbar sind. Die Verbindung wird hergestellt, indem der Zapfen in die Aussparung eingeführt wird und anschließend oder gleichzeitig mit dem Einführen eine Kaltverschweißung des Zapfens mit der Aussparung erfolgt.

## Beschreibung

Die vorliegende Erfindung betrifft eine neuartige Aufbau- und Verbindungstechnik, insbesondere für die Leistungselektronik.

Die Aufbau- und Verbindungstechnik hat die Aufgabe, elektrische und mechanische Verbindungen zwischen den einzelnen Elementen einer Schaltung und ggf. einem Schaltungsträger zu schaffen.

Insbesondere für Leistungshalbleiter hat es sich als vorteilhaft herausgestellt, diese mit Kontakten oder Kontaktflächen an mehreren Seiten auszustatten, also beispielsweise leiterplattenseitigen Kontakten und oberseitigen Kontakten. Verschiedene Aufbau- und Verbindungstechniken sind bekannt und in der Publikation "Applikationshandbuch Leistungshalbleiter", Herausgeber Semikron International GmbH, 2. Auflage 2015, ISBN 978-3-938843-85-7, in Kapitel 2.5 ausführlich beschrieben.

Das dort beschriebene Drahtbonden an der Oberseite hat allerdings den Nachteil, dass während der Herstellung der Verbindung Kräfte aufgewendet werden, durch welche das Halbleiterbauelement beschädigt werden können. Zudem können im Betrieb lokale Temperaturerhöhungen entstehen, denen durch die Verwendung von mehreren Bonddrähten und dem sogenannten Stitching nur bedingt entgegengewirkt werden kann. Die Kontaktierungspunkte sind unvermeidbar einer punktuellen thermischen Belastung ausgesetzt und auch die Bonddrähte erwärmen sich aufgrund des während des Betriebs durch sie fließenden Stroms und ihres durch das Bondverfahren begrenzten Querschnitts. Ferner können aufgrund von Induktion in den Bonddrähten unerwünschte elektrische Störsignale in die Schaltung eingebracht werden, insbesondere kann bei parallel verlaufenden Bonddrähten, die zu verschiedenen Kontakten führen, ein unerwünschtes Übersprechen auftreten.

Als Alternative zu Bonddrähten sind u.a. aus vorstehend genannter Publikation Sinterverfahren bekannt, die im Gegensatz zu den Bonddrähten flächige Verbindungen mit deutlich größeren Querschnitten erlauben und sowohl trägerseitig als auch oberseitig einsetzbar sind und sich gegenüber Lötverbindungen durch eine deutlich höhere Temperaturbeständigkeit auszeichnen. Nachteilig an diesen Sinterverfahren ist jedoch der hohe Fertigungsaufwand bei Bestückung der Leiterplatten bzw. Schaltungsträger und insbesondere der hohe Druck, der für den Sintervorgang erforderlich ist.

Schließlich sind u.a. ebenfalls aus der vorstehend genannten Publikation Druckkontaktierungen bekannt, die an die Stelle der vorgenannten stoffschlüssigen Verbindungsarten treten. Dabei gleiten die verbundenen Partner aufeinander und vermeiden damit thermische Spannungen, die bei den stoffschlüssigen Verbindungen im Betrieb zwangsläufig auftreten und z.B. mittels geeignet flexibler Materialien kompensiert werden müssen. Druckkontaktierungen haben allerdings den Nachteil, dass auf den Halbleiter dauerhaft Druck ausgeübt wird, der sich mit der Temperatur ändert und das Halbleiterbauelement im Laufe der Zeit beschädigen kann. Zudem erfordern flächige Kontaktierungen perfekt ebene Flächen und es muss sichergestellt werden, dass die aufeinander gleitenden Kontakte dauerhaft frei von Verschmutzungen und Oxidschichten bleiben.

Aus der WO 2021/013401 A1 sind formschlüssige Verbindungen zwischen einer Entwärmungskörperanordnung und einem Leistungshalbleiter bekannt, die durch eine Vielzahl stelenartiger Entwärmungskörper und dazu korrespondierenden Kavitäten gebildet werden, um die Oberfläche der Kontaktierung zu erhöhen und die Nachteile der Druckkontaktierungen zu vermeiden, indem nach erfolgter Montage keine Kräfte mehr auf die Oberfläche des Halbleiters wirken. Allerdings erfordert die Montage der Entwärmungskörperanordnung einen zusätzlichen Arbeitsschritt, nämlich das Verkleben oder Verlöten der Verbindung.

Eine Aufgabe der vorliegenden Erfindung ist es, eine weiter verbesserte Aufbau- und Verbindungstechnik anzugeben.

Diese Aufgabe wird durch besonders geformte elektrische Kontakte eines auf einen Schaltungsträger aufbringbaren Schaltungselements sowie des dazu passenden elektrischen Verbinders gelöst. Erfindungsgemäß weist einer der Kontakte einen flächigen Abschnitt auf, auf dem ein Zapfen ausgebildet ist, und der Partnerkontakt weist eine dazu passende Aussparung auf. Im verbundenen Zustand bildet der Zapfen mit der Aussparung eine kaltgeschweißte Verbindung.

Die vorliegende Erfindung betrifft ferner ein Verfahren zum Herstellen einer elektrischen Verbindung zwischen einem auf einem Schaltungsträger anbringbaren Schaltungselement und einem weiteren Element, die über Kontakte wie vorstehend beschrieben verfügen, wobei das leitfähige Material des Zapfens und das leitfähige Material der Aussparung so gewählt werden, dass diese kaltverschweißbar sind. Die Verbindung wird hergestellt, indem der Zapfen in die Aussparung eingeführt wird und anschließend oder gleichzeitig mit dem Einführen eine Kaltverschweißung von Zapfen und Aussparung erfolgt.

Die erfindungsgemäße Aufbau- und Verbindungstechnik hat dabei den wichtigen Vorteil, dass zuverlässige und dauerhafte elektrische und mechanische Verbindungen geschaffen werden können, und zwar ohne Erhitzen der Verbindungsstelle. Halbleiter können also bei Raumtemperatur angebunden werden und es können damit z.B. auch innerhalb polymerbasierter Gehäuse Verbindungen hergestellt werden, ohne dass (wie bei herkömmlichen wärmebasierten Fügeverfahren wie Löten oder Sintern) Sorge getragen werden muss, dass das Gehäuse durch die Erwärmung beschädigt wird. Nach Herstellen der Verbindung wird vorteilhafterweise kein Druck mehr auf die Schaltungselemente ausgeübt.

Dabei spielt es keine Rolle, welcher der Kontakte den Zapfen und welcher der Kontakte die Aussparung aufweist.

In Ausführungsbeispielen sind mehrere dieser Fügepaare bestehend aus Zapfen und Aussparung vorgesehen. Die Aussparung ihrerseits kann zwischen zumindest einem auf dem jeweiligen flächigen Abschnitt angeordneten weiteren Zapfen und mindestens einem weiteren auf dem jeweiligen flächigen Abschnitt angeordneten Element gebildet wird. Bei dem weiteren Element kann es sich um zwei oder drei weitere Zapfen handeln. Dabei können die weiteren Zapfen hohl ausgebildet und damit leichter kalt verformbar gegenüber den zwischen den weiteren Zapfen im verbundenen Zustand eingebrachten Zapfen sein.

Die Zapfen und/oder die weiteren Zapfen und/oder die Aussparungen können in einem Raster angeordnet sein, vorzugsweise in einem quadratischen Raster, um so eine multifunktionale und flexibel in zwei Vorzugsrichtungen nutzbare Verbindungs- und Aufbautechnik zu bilden. Ein Vorteil dieser Ausgestaltung besteht dabei darin, dass viele Gleichteile verwendet werden können und so Kosten gesenkt werden können.

Ein erfindungsgemäßes Schaltungs- und/oder Verbindungselement kann in einer Ausgestaltung mindestens einen weiteren elektrischen Kontakt aufweisen, der ebenfalls einen flächigen Abschnitt aufweist, welcher im Wesentlichen parallel zum flächigen Abschnitt des erstgenannten Kontakts orientiert ist und wobei der flächige Abschnitt des Kontakts nur Zapfen und der flächige Abschnitt des weiteren Kontakts nur Aussparungen aufweist.

Anders ausgedrückt kann die erfindungsgemäße Technik sowohl trägerseitig als auch an der Oberseite verwendet werden. Dabei können an einem Kontakt an einer Unterseite eines Schaltungs- und/oder Verbindungselements Aussparungen zum Aufsetzen und Verbinden dieses Elements mit dem oder den Zapfen eines darunterliegenden Elements oder des Schaltungsträgers angeordnet sein und an einem Kontakt an der Oberseite des Schaltungs- und/oder Verbindungselements können ein oder mehrere Zapfen angeordnet sein, die ihrerseits zur Verbindung mit entsprechenden Aussparungen eines aufzusetzenden Elements dienen. Gleichermaßen können Kontakte vorgesehen werden, die an einer Unterseite Aussparungen und an einer Oberseite Zapfen aufweisen oder umgekehrt. Durch diese beiden Maßnahmen kann vorteilhaft erreicht werden, dass Schaltungs- und Verbindungselemente stapelbar sind. Natürlich ist es auch möglich, Elemente zu schaffen, mit denen die Stapel- bzw. Aufbaurichtung umgekehrt werden kann, die also sowohl auf der Oberseite als auch auf der Unterseite nur Zapfen oder nur Aussparungen aufweisen.

In anderen Ausgestaltungen der Erfindung kann vorgesehen werden, dass auf einer Kontaktfläche sowohl Zapfen als auch Aussparungen vorgesehen sind, die sich vorzugsweise in einem geeigneten Raster abwechseln.

In einer vorteilhaften Weiterbildung der Erfindung ist/sind die Aussparung(en) als Durchgangsbohrung(en) ausgeführt und der/die Zapfen sind so ausgebildet, dass er/sie nach dem vollständigen Einführen in die Durchgangsbohrung(en) auf der anderen Seite der Durchgangsbohrung herausragt/en. Die Kaltverschweißung wird dann bewirkt, indem der/die Zapfen zumindest teilweise in der/den Durchgangsbohrung(en) des Partnerkontakts verpresst wird/werden. Dabei kann vorgesehen sein, dass ein bestimmter Teil des/der Zapfen/s nach der Verpressung ähnlich wie ein Nietkopf weiterhin über die Durchgangsbohrung herausragt und eine zusätzliche flächige Kontaktierung sowie eine zusätzliche mechanische Sicherung der Verbindung bewirkt.

Vorteilhafterweise werden, wenn mehrere Zapfen und korrespondierende Aussparungen vorhanden sind, diese im Wesentlichen gleichzeitig gefügt.

Im folgenden werden Ausführungsbeispiele der vorliegenden Erfindung anhand von Zeichnungen näher erläutert. Es sei darauf hingewiesen, dass sämtliche vorstehend und nachfolgend offenbarten Varianten, Ausgestaltungen und Ausführungsbeispiele uneingeschränkt miteinander kombinierbar sind, und zwar sowohl hinsichtlich des Schaltungselements, des elektrischen Verbinders als auch des Verfahrens.

Es zeigen:
Fig. 1A in schematischer Darstellung einen auf einem Träger aufgebrachten Halbleiterbaustein gemäß eines Ausführungsbeispiels der vorliegenden Erfindung;
Fig. 1B den Halbleiterbaustein aus Fig. 1A mit oberseitiger Kontaktierung gemäß eines Ausführungsbeispiels der vorliegenden Erfindung;
Fig. 2A, B einen elektrischen Verbinder gemäß eines Ausführungsbeispiels der vorliegenden Erfindung in Draufsicht bzw. Ansicht von unten;
Fig. 3 ein weiteres Ausführungsbeispiel der vorliegenden Erfindung mit gestapelten Elementen; und
Fig. 4 eine besondere Zapfen- und Aussparungsform gemäß eines weiteren Ausführungsbeispiels der vorliegenden Erfindung.

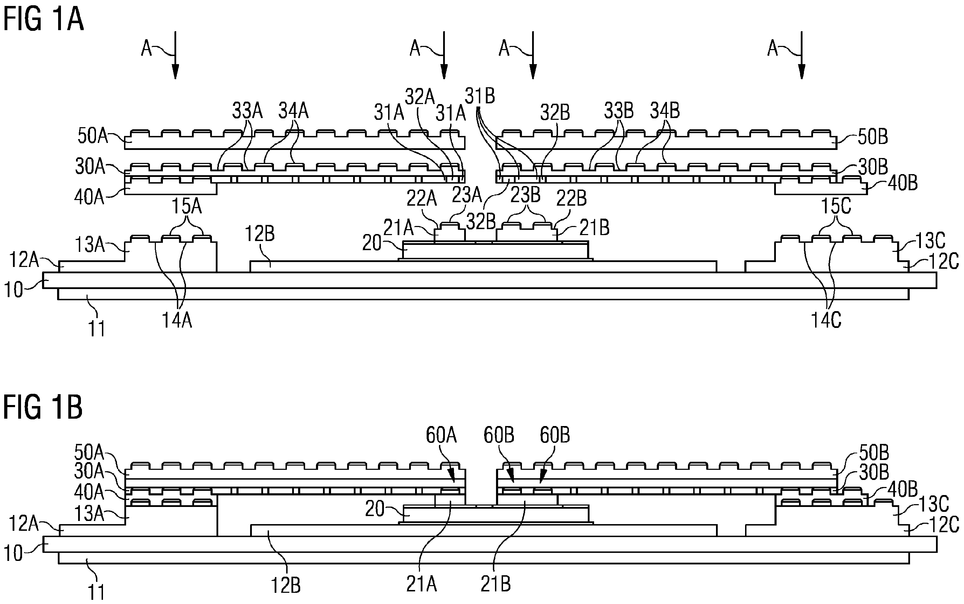

Fig. 1A zeigt in schematischer Darstellung einen bereits auf einem Träger 10 aufgebrachten Leistungshalbleiterbaustein 20.
Dabei kann der Leistungshalbleiterbaustein 20 mit dem im folgenden beschriebenen Verfahren auf dem Träger 10 aufgebracht sein oder mit einem herkömmlichen Verfahren, beispielsweise durch Auflöten oder durch Sinterverfahren.

Bei dem Träger 10 kann es sich um ein herkömmliches Printed Circuit Board (PCB) handeln, ein Active Metal Braze Substrat (AMB) oder um einen Direct Copper Bond (DCB) Träger, um einen oder mehrere Leadframes oder um ein organische Dick-Kupfer-Polymer-Substrat. Mit Dick-Kupfer-Substrat sind dabei Kupferdicken von mehr als 0,3 mm gemeint, also beispielsweise 1,0 mm, 2,0 mm oder 4,0 mm.

Der Leistungshalbleiter 20 ist also trägerseitig, d.h. in der Darstellung der Fig. 1A unterseitig, bereits elektrisch und mechanisch mit einer Leiterschicht 12B des Trägers 10 verbunden. Auf der oberen Seite weist der Leistungshalbleiter 20 ebenfalls Kontaktmittel 21 auf, nämlich einen ersten Kontakt 21A und einen zweiten Kontakt 21B. Die Kontakte 21 weisen jeweils (im Beispiel der Fig. 1A schmale) flächige Abschnitte 22 auf, auf denen Kontaktzapfen bzw. Kontaktstifte bzw. Kontaktpillars 23 ausgebildet sind.

Die Kontaktzapfen 23 sind so gestaltet, dass sie zu Vertiefungen 32 passen, die an der Unterseite von elektrischen Verbindern 30 ausgebildet sind.

Anzahl, Form und Dimension der Zapfen und der Aussparungen können je nach Anwendung und der für Zapfen und Vertiefungen gewählten Herstellungstechnologie in einem breiten Rahmen frei gewählt werden. Beispielsweise ist es möglich, die Zapfen säulenförmig bzw. pillarförmig auszugestalten, d.h. mit einem im Vergleich zur Länge kleinen Durchmesser, beispielsweise mit einer Länge von 2,0 mm und einem Durchmesser von 0,5 mm. In anderen Ausgestaltungen ist es möglich, den Durchmesser der Zapfen größer zu wählen als deren Höhe, wie in Fig. 1A angedeutet. Ferner ist es möglich, beispielsweise bei nur geringer elektrischer oder thermischer Belastung, wenige Fügepaare oder nur ein Fügepaar vorzusehen. In anderen Anwendungen ist es hingegen sinnvoll, eine Vielzahl von Fügepaaren zu verwenden, beispielsweise um die gesamte Kontaktierungsfläche, die mit der Zahl der Zapfen bzw. Pillars steigt, zu erhöhen.

Die Zapfen 23 können vorzugsweise zylindrisch mit kreisförmigem Querschnitt ausgebildet sein, es kommen aber auch andere Querschnitte wie Ellipsen, Dreiecke, Vierecke, insbesondere Quadrate usw. in Betracht, die auch komplexere Formen annehmen können, die also beispielsweise (wenn seitlich betrachtet) Verjüngungen, Hinterschnitte oder Verbindungen zueinander aufweisen können. Wichtig ist lediglich, dass Zapfen 23 und Aussparungen 32 so zueinander passen, dass sie unter Ausübung einer definierten maximalen Kraft zu einem Fügepaar gefügt werden können.

Im Beispiel der Fig. 1A weist ein erster Kontakt 21A des Leistungshalbleiters 20 einen Zapfen 23A oder eine sich in die Bildebene hinein erstreckende Zapfenreihe auf. Ein zweiter Kontakt 21B weist zwei Zapfen 23B oder zwei sich in die Bildebene hinein erstreckende Zapfenreihen auf. Über den zweiten Kontakt 21B kann somit ein entsprechend höherer Strom geleitet und/oder mehr Wärme abgeleitet werden, falls die Ausdehnung der Kontakte 21A, 21B in die Bildebene hinein gleich ist. Durch Vergrößerung der Fügefläche nach rechts oder links oder in die Bildebene hinein bzw. aus der Bildebene heraus mit ggf. zusätzlichen Zapfen oder Zapfenreihen können für die Kontakte 21 die Stromtrage- und/oder Wärmeableitfähigkeit vergrößert sowie die mechanischen Eigenschaften der Fügeverbindung verbessert werden.

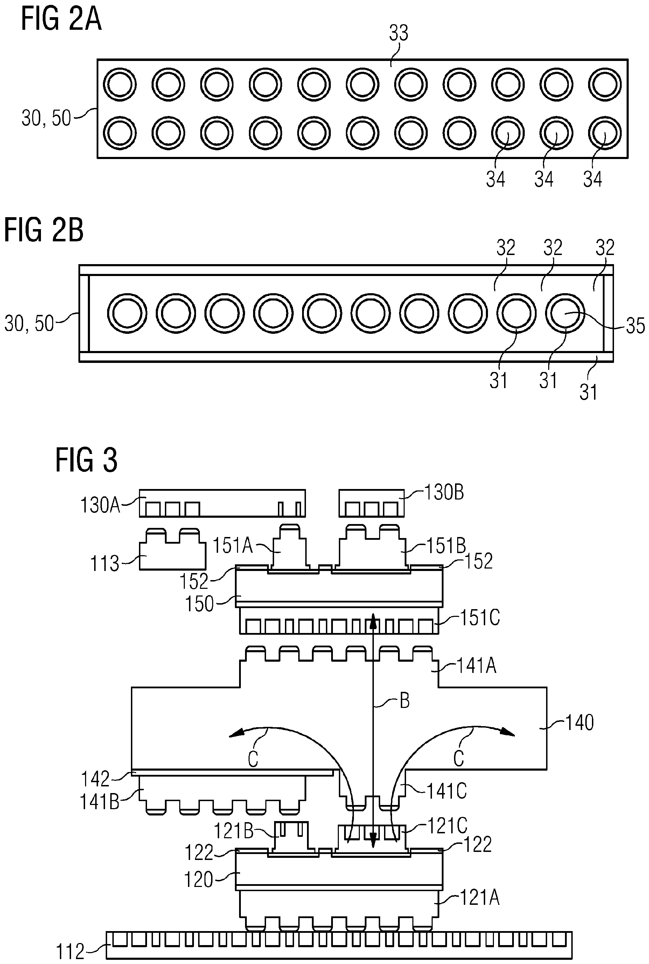

Fig. 1A zeigt einen ersten elektrischen Verbinder 30A und einen zweiten Verbinder 30B im noch nicht mit dem Leistungshalbleiter verbundenen Zustand. Die Verbinder sind an der Unterseite flächig gestaltet, weisen jedoch viele Materialausnehmungen auf, so dass von der ursprünglichen unteren Fläche nur noch schmale Abschnitte 31A, 31B sowie die Randbereiche (siehe Fig. 2B) verbleiben, die im verbundenen Zustand mit den schmalen flächigen Abschnitten 22A, 22B der Kontakte 21A, 21B des Leitungshalbleiters 20 in Kontakt stehen. Aussparungen 32A, 32B sind an der Unterseite der Verbinder 30A, 30B angeordnet und hinsichtlich Form und Material so gestaltet, dass sie die Zapfen 23A, 23B der Kontakte 21A, 21B formschlüssig aufnehmen und mit diesen kaltverschweißt werden können.

Der erste Verbinder 30A dient dabei der Verbindung des ersten Kontakts 21A des Leistungshalbleiterbausteins 20 mit einer ersten Leiterfläche 12A des Trägers 10 und der zweite Verbinder 30B dient der Verbindung des zweiten Kontakts 21B des Leistungshalbleiterbausteins 20 mit einer dritten Leiterfläche 12C des Trägers 10. Der Leistungshalbleiter ist unterseitig mit einer zweiten Leiterfläche 12B des Trägers 10 verbunden. Ferner kann Träger 10 unterseitig eine weitere Leiterschicht 11 aufweisen, die für die vorliegende Erfindung aber nicht weiter von Belang ist.

Vorzugsweise werden im wesentlichen platten- oder plättchenförmige Verbinder 30A, 30B verwendet. In diesem Fall kann es erforderlich sein, die Kontaktierung mit den entsprechenden Leiterflächen 12A, 12C der Bauhöhe des Leistungshalbleiters 20 anzupassen, da die platten- oder plättchenförmige Verbinder 30A, 30B nur geringe Höhenunterschiede ausgleichen können und es bei größeren Höhenunterschieden zu ungewollten Biegebeanspruchungen der Verbinder 30A, 30B kommen kann oder nach Montage eine Biegespannung verbleibt, die auf die hergestellte Fügung wirkt und diese im Laufe der Zeit möglicherweise trennt.

Im Beispiel der Fig. 1A sind mehrere Anpassungselemente 13, 40 dargestellt, die diese Anpassung an die Bauhöhe des Leistungshalbleiters 20 sowie seiner Kontakte 21 bewirken. Dabei sind erste Anpassungselemente 13A, C bereits auf den Leiterflächen 12A, C montiert oder wurden im Herstellungsprozess des Trägers dort einstückig mit den Leiterflächen 12A, C erstellt. Zweite Anpassungselemente 40A, 40B sind bereits an den Verbindern 30A, 30B montiert oder einstückig mit diesen ausgebildet. Die Montage kann in beiden Fällen mit dem hier beschriebenen Fügeprinzip erfolgen, d.h. mit entsprechenden Fügepaaren umfassend Zapfen und Aussparungen, oder mittels herkömmlicher Techniken wie Löten oder Sintern, da diese vom Halbleiter 20 entfernt gelegenen Fügestellen nicht hitzeempfindlich sind.

In anderen Ausführungsbeispielen kann es sich bei den Elementen 13 nicht um Anpassungselemente handeln, sondern um die Kontakte weiterer aktiver oder passiver Schaltungselemente mit einer vom Halbleiter 20 verschiedenen Bauhöhe.

Im Beispiel der Fig. 1A sind die auf den Leiterflächen 12A, C aufgebrachten ersten (Anpassungs-)Elemente 13 oberseitig mit Zapfen 15 versehen, die in Form und Funktion den Zapfen 23 der Kontakte 21 des Halbleiterbauelements 20 entsprechen. Passend zur Form der Oberseite der Elemente 13 und insbesondere der Lage, Form und Anzahl der Zapfen 15 sind die zweiten Anpassungselemente 40A, 40B unterseitig mit Aussparungen versehen (nicht im Detail dargestellt), die in Form und Funktion den Aussparungen 32 der Verbinder 30A, 30B entsprechen. Vorteilhaft ist es dabei, systemweit einheitliche Zapfen und Aussparungen zu verwenden, dies ist aber nicht zwingend erforderlich. In anderen Ausgestaltungen kann beispielsweise durch verschiedene Zapfen- und Aussparungsformen die Montagerichtung vorgegeben oder besonderen Anforderungen an die Kontaktierung an bestimmten Stellen Rechnung getragen werden.

Im Beispiel der Fig. 1A sind ferner optionale Verstärkerplatten 50A, 50B dargestellt, die in Form, Aufbau und Funktion vorzugsweise den Verbindern 30A, 30B entsprechen, um mit möglichst wenigen verschiedenen Teilen die jeweilige konstruktive und/oder elektrotechnische Aufgabe flexibel lösen zu können. Die Verbinder 30A, 30B sind oberseitig vorzugsweise flächig oder weisen flächige Abschnitte 33A, 33B auf, auf denen Zapfen 34A, 34B angeordnet sind. Die Verstärkerplatten 50A, 50B weisen unterseitig dazu passende Aufnahmen auf (nicht im Detail dargestellt). Wiederum vorzugsweise entsprechen die Zapfen 34A, 34B in Form und Funktion den Zapfen 23 der Kontakte 21 des Halbleiterbauelements 20, und die Aussparungen entsprechen in Form und Funktion den Aussparungen 32 der Verbinder 30A, 30B. Natürlich ist es möglich, auf die vorstehend beschriebene Weise weitere Verstärkerplatten auf den Verstärkerplatten 50 zu montieren, beispielsweise um die Stromtrage- und/oder Wärmeableitfähigkeit der Verbinder weiter zu erhöhen.

Wie bereits im Fall der zweiten Anpassungselemente 40A, 40B können auch die Verstärkerplatten 50A, 50B bereits mit den Verbindern 30A, 30B zusammengefügt sein, bevor die Verbinder mit dem Halbleiter 20 verbunden werden. Dies ist insbesondere dann vorteilhaft, wenn die Verbinder 30 und die Verstärkerplatten 50 eine Mehrzahl von Fügepaaren aufweisen und durch einen über die gesamte Fläche auszuübenden Druck gefügt werden, da bei einer weniger zu bevorzugenden gleichzeitigen Verpressung sowohl der Verbinder 30 mit den Verstärkerplatten 50 als auch der Verbinder 30 mit den Kontakten 21 und den Anpassungselementen 15 in größeren Zwischenbereichen keine Gegenkraft von den Verbindern ausgeübt werden kann (siehe die in Fig. 1B gezeigten freien Bereiche unterhalb der Verbinder 30) und die Fügequalität zwischen Verbinder 30 und Verstärkerplatte 50 dann nicht optimal ist.

Im folgenden wird davon ausgegangen, dass die Verbinder 30 bereits mit den Ausgleichselementen 40 und, soweit diese erforderlich sind, auch mit den Verstärkerplatten 50 bereits montiert sind.

Die Verbinder 30 werden dann auf die Kontakte 21 der der Halbleiterschaltung sowie auf Kontakte 13 der Trägerplatte aufgesetzt bzw. zueinander ausgerichtet, und zwar so, dass die Zapfen 23, 15 in die entsprechenden Aussparungen eingeführt werden können. An den Zapfen und/oder den Aussparungen können Führungs- bzw. Zentrierhilfen vorgesehen sein, beispielsweise in Form von Fasen an den Zapfen oder konisch zulaufenden Öffnungen der Aussparungen, um die Montage zu erleichtern.

Anschließend wird ein definierter Fügedruck auf die zu fügenden Stellen ausgeübt, angedeutet durch Pfeile A in Fig. 1A, und die Zapfen hierdurch vollständig in die Aussparungen hineingepresst und die Zapfen werden dabei mit den Aussparungen kaltverschweißt.

Fig. 1B zeigt den Zustand nach dem Zusammenfügen der in Fig. 1A separat dargestellten Elemente. Der Halbleiter 20 ist mittels des erfindungsgemäßen Verfahrens nun oberseitig kontaktiert, dabei sind die Kontakte 21A, 21B mittels Kaltverschweißungen 60A, 60B mit den Verbindern 30A, 30B elektrisch leitend und vorzugsweise auch thermisch leitend verbunden. Gleichermaßen sind die Verbinder 30A, 30B mit den Leiterflächen 12A, 12C elektrisch leitend verbunden. Die Kaltverschweißungen sind dabei unlösbar und halten mechanischen Belastungen, z.B. hervorgerufen durch thermische Ausdehnungen, innerhalb (z.B. durch die Zahl der Fügepaare bestimmter) Grenzen stand, und zwar in allen Belastungsrichtungen.

Die in Fig. 1A gezeigten Zapfen und Aussparungen können durch verschiedene Verfahren hergestellt werden. Bei den Verbindern 30, den Ausgleichselementen 13, 40 und den Verstärkerplatten 50 bieten sich Verfahren an, die in einem Verfahrensgang das jeweilige Element erzeugen, also beispielsweise Präge- oder Druckgussverfahren, aber auch die im folgenden beschriebenen Verfahren, die sich besonders zum Herstellen von Zapfen oder Pillars auf dem Halbleiterbauelement 20 eignen.

Insbesondere dort bieten sich additive Fertigungsverfahren an, aber auch galvanische Fertigungsverfahren sowie thermische Sprühverfahren und/oder Sinterverfahren, insbesondere mit Silber, Kupfer oder Aluminium. Der Begriff "thermische Sprühverfahren" wird hier als Oberbegriff u.a. für folgende Verfahren verwendet: Aufbringen von Material durch Zerstäuben aus einer Schmelze (Schmelzbadspritzen), Aufbringen von Material durch elektrische Lichtbogen- oder Gasentladung (z.B. Lichtbogenspritzen oder Plasmaspritzen), Aufbringen von Material durch Gasexpansion ohne Verbrennung (z.B. Kaltgasspritzen), Aufbringen von Material mit Hilfe von Verbrennungsprozessen (z.B. Drahtflammspritzen, Pulverflammspritzen, Hochgeschwindigkeitsflammspritzen, Detonationsspritzen) oder Aufbringen von Material mit Hilfe gebündelter energetischer Strahlen (z.B. Laserspritzen).

Als Material für die Zapfen bzw. Pillars und als die Aussparungen umgebende Materialien kommen insbesondere Cu, Ag, Au, Fe, Sn, Ni, Al, Mo, Wo bzw. Legierungen aus mindestens einem dieser Elemente in Betracht. Aber auch Halbmetalle, Metall-Keramiken, hochdotierte Halbleiter wie beispielsweise Si, SiC, GaN oder graphitbasierte Materialien können verwendet werden. Die Zapfen bzw. Pillars können auch aus verschiedenen Materialkombinationen aufgebaut sein, wie z.B. Kupfer an einem Ende des Pillars und Graphit am anderen Ende.

Um einen effizienten elektrischen Kontakt zwischen Zapfen und Aussparung zu gewährleisten, können die Zapfen und/oder die Aussparungen mit einem metallischen Material oder Lot überzogen bzw. ausgekleidet sein, beispielsweise mit Sn, Au, Ag. Hierdurch kann beispielsweise durch eine oxidfreie Oberfläche (Au) und/oder durch ein "Verschmieren" eines weichen Metalls (Sn) eine Kaltverschweißung hoher Qualität erleichtert werden.

Fig. 2A zeigt einen der in Fig. 1 dargestellten Verbinder 30, der bevorzugt baugleich zu den in Fig. 1 ebenfalls dargestellten Verstärkerplatten 50 ist, in Draufsicht, bezogen auf die bevorzugte Einbaurichtung. Der in Fig. 2A beispielhaft dargestellte Verbinder ist im wesentlichen flächig mit einer Kontaktfläche 33 und weist 22 Zapfen auf, die in zwei Reihen mit jeweils 11 Zapfen 34 angeordnet sind. Dabei folgt die Anordnung der Zapfen 34 einem quadratischen Raster, wobei die Eckpunkte des Raster-Basisquadrats durch die Mittelpunkte der hier im wesentlichen zylindrischen Zapfen gebildet werden. In der Fertigung können solche Verbinder 30 bzw. Verstärkerplatten 50 aus großen Platten (beispielsweise 100x100 Zapfen) einfach ausgestanzt werden oder von Endlosrollen (beispielsweise mit einer Breite von zwei Zapfen) abgeschnitten werden. Alternativ ist es natürlich auch möglich, nach Art eines Baukastens verschiedene Standardgrößen zu bevorraten.

Fig. 2B zeigt den in Fig. 2A dargestellten Verbinder 30 bzw. die Verstärkerplatte 50 von unten, bezogen auf die Einbaurichtung. Die Unterseite des Verbinders 30 bzw. der Platte 50 weist einen flächigen Abschnitt 31 auf, der in diesem Beispiel wenig ausgeprägt ist und gebildet wird von den Unterseiten der umlaufenden Kanten des im wesentlichen rechteckigen Verbinders 30 sowie von den unteren Flächen von weiteren Zapfen 35 (im folgenden: Unterseitenzapfen 35). Im Beispiel der Fig 2B sind zehn derartige Unterseitenzapfen 35 dargestellt, die gemeinsam mit den umlaufenden Kanten insgesamt 22 Aussparungen 32 bilden, die in zwei Reihen zu je 11 Aussparungen angeordnet sind und passend zu den Zapfen 23 an der Oberseite der Kontakte 21 des Leistungshalbleiters 20 geformt sind. Dabei sind die Unterseitenzapfen vorzugsweise hülsenförmig ausgestaltet, d.h. innen hohl, um einerseits Material zu sparen und andererseits den Unterseitenzapfen 35 eine definierte Verformbarkeit gegenüber den (Oberseiten-)Zapfen 23, 34 zu verleihen. Die Wandstärke bestimmt gemeinsam mit dem Material den Widerstand der Unterseitenzapfen und damit die Klemmkraft bzw. den Kaltverschweißungsdruck. In anderen Ausführungsbeispielen, insbesondere im Zusammenhang mit schlanken (Oberseiten-)Zapfen 34, können die Unterseitenzapfen auch aus Vollmaterial erstellt sein. Die für die Kaltverschweißung erforderliche Materialverdrängung erfolgt dann durch die gegenseitige Ausübung von Verdrängungskräften der Oberseitenzapfen und der Unterseitenzapfen gegeneinander in Richtung der zwischen den Zapfen an der Unterseite verbleibenden Freiräume.

Dabei werden die Aussparungen, in denen die Zapfen aufgenommen und kaltverschweißt werden, im in Fig. 2B gezeigten Beispiel stets zwischen einem oder zwei Unterseitenzapfen bzw. einer oder zwei Unterseitenhülse(n) und der umlaufenden Kante gebildet. Auch wenn eine gute Verbindung bereits mit einem Zapfen erreicht werden kann, nimmt natürlich die elektrische, mechanische und thermische Belastbarkeit mit der Zahl der in Verschweißungspaare zu. Vorzugsweise wird beispielsweise das in Fig. 2 dargestellte Element mit mindestens zwei, besser mit vier Zapfen gefügt bzw. verschweißt, wobei diese vier Zapfen dabei vorzugsweise im Quadrat angeordnet sind und somit einen der Unterseitenzapfen bzw. Hülsen 35 umschließen. In anderen Ausgestaltungen können Verbinder mit einer Breite von mehr als zwei Zapfen/Aussparungen eingesetzt werden.

Anders ausgedrückt beschreibt die vorliegende Erfindung in erster Linie ein Fügepaar bestehend aus einem Zapfen und einer Aussparung, das als Basiselement für ein baukastenartiges System von beliebig geformten, aber dem oben genannten quadratischen Raster folgenden, auf einem Träger 10 montierbaren Bauelementen mit entsprechenden oberseitigen Kontakten und den dazugehörigen Verbindungselementen dienen kann. Derartige baukastenartige Systeme sind als Kunststoff-Klemmbausteine beispielsweise der Firma LEGO wohlbekannt und alle dort bekannten Formen können anhand der vorliegenden Offenbarung auf die neuartige Aufbau- und Verbindungstechnik übertragen werden. Dabei kann der Träger 10 selbst über Zapfen und/oder Aussparungen verfügen, bevorzugt ausschließlich im Bereich von leitenden Flächen oder Bahnen 12, im allgemeinen aber auch im Bereich nichtleitender Flächen, wobei die Zapfen und/oder Aussparungen im Bereich nichtleitender Flächen dann bevorzugt keine Kaltschweißverbindung eingehen, sondern nur der Führung und zusätzlichen mechanischen Stabilisierung der auf dem Träger mittels Kaltverschweißung montierten Bauelemente oder Verbinder dienen.

Einige der durch die Modularität möglichen Varianten werden anhand des in Fig. 3 dargestellten Ausführungsbeispiels im folgenden näher erläutert. Fig. 3 zeigt ein Ausführungsbeispiel mit gestapelten Elementen, die gemäß der vorliegenden Erfindung verbindbar sind. Die Elemente sind dabei in einer Art Explosionszeichnung im zueinander ausgerichteten, aber nicht gefügten Zustand dargestellt, aus welcher die herzustellenden Verbindungen eindeutig erkennbar sind.

Ein erster Leistungshalbleiter 120 ist montierbar auf einer Leiterfläche 112. Bei der Leiterfläche 112 kann es sich um eine Leiterfläche eines Trägers handeln (nicht dargestellt). In anderen Ausgestaltungen des in Fig. 3 gezeigten Ausführungsbeispiels bildet ein Kühlkörper 140 den gemeinsamen Träger und die Leiterfläche 112 ist lediglich ein Verbinder wie in Fig. 2 dargestellt.

Der erste Leistungshalbleiter 120 weist einen ersten, hier unteren, elektrischen Kontakt 121A auf, der über sechs Zapfen bzw. Zapfenreihen in entsprechende Aufnahmen bzw. Aussparungen der Leiterfläche 112 nach dem vorstehend ausführlich beschriebenen Prinzip einsetzbar und mit diesen kaltverschweißbar ist.

Der erste Leistungshalbleiter 120 weist oberseitig einen optionalen flächigen Isolator 122 sowie einen zweiten elektrischen Kontakt 121B auf, der eine Aussparung bzw. eine Reihe von Aussparungen zur Aufnahme eines mit dem Kühlkörper 140 mechanisch verbundenen Kontakts bzw. Verbinders 141B aufweist. Dabei ist der Kontakt bzw. Verbinder 141B mit entsprechenden Zapfen zum Einsetzen und Kaltverschweißen mit der/den Aussparung(en) des zweiten Kontakts 121B des ersten Leistungshalbleiters ausgestattet. Der Kontakt bzw. Verbinder 141B ist durch einen flächigen Isolator 142 elektrisch vom Kühlkörper 140 isoliert und beispielsweise auf diesen aufgeklebt.

Der erste Leistungshalbleiter 120 weist außerdem einen dritten elektrischen Kontakt 121C auf, der zwei Aussparungen bzw. zwei Reihen von Aussparungen zur Aufnahme eines mit dem Kühlkörper 140 mechanisch und elektrisch verbundenen Kontakts bzw. Verbinders 141C aufweist. Dabei ist der Kontakt bzw. Verbinder 141C mit entsprechenden Zapfen zum Einsetzen und Kaltverschweißen mit den Aussparungen des dritten Kontakts 121C des ersten Leistungshalbleiters 120 ausgestattet. Der Kontakt bzw. Verbinder 141C dient sowohl der elektrischen Kopplung zwischen dem ersten Leistungshalbleiter 120 und dem Kühlkörper 140, der auch die Funktion des elektrischen Leiters zwischen dem ersten Leistungshalbleiter 120 und einem zweiten Leistungshalbleiter 150 übernimmt (angedeutet durch Doppelpfeil B), als auch der thermischen Kopplung des ersten Leistungshalbleiters 120 an den Kühlkörper 140 zwecks Entwärmung des ersten Leistungshalbleiters 120 (angedeutet durch Pfeile C).

Oberseitig weist der Kühlkörper 140 einen Kontakt bzw. Verbinder 141 auf, der über sechs Zapfen bzw. sechs Reihen von Zapfen mit einem dritten elektrischen Kontakt 151C des zweiten Leistungshalbleiters 150 verbindbar ist. Der dritte Kontakt 151C des zweiten Leistungshalbleiters weist entsprechende Aufnahmen bzw. Aussparungen auf und ist auf die Zapfen des Kontakts bzw. Verbinders 141 an der Oberseite des Kühlkörpers 150 nach dem weiter oben ausführlich beschriebenen Prinzip aufsetzbar und mit diesen kaltverschweißbar. Es sei darauf hingewiesen, dass der Kühlkörper 140 sowohl an der Unterseite als auch an der Oberseite jeweils Zapfen aufweist und damit eine Umkehr der Orientierung der Zapfen-Aussparungs-Richtung bewirkt. Natürlich kann alternativ ein Kühlkörper verwendet werden, der an einer der beiden Seiten Zapfen und an der anderen Seite Aussparungen aufweist - dies hängt ganz vom Einsatzzweck und den mit dem Kühlkörper zu verbindenden Bauelementen sowie deren Orientierung ab.

Der zweite Leistungshalbleiter weist oberseitig einen flächigen Isolator 152 sowie einen ersten Kontakt 151A und einen zweiten Kontakt 151B auf, die mit Verbindern 130A, 130B über Zapfen und Aussparungen wie dargestellt verbind- und verschweißbar sind. Die hier dargestellten Verbinder 130A, 130B können als Abschlussverbinder bezeichnet werden und zeichnen sich dadurch aus, dass sie oberseitig keine Zapfen und/oder keine Aussparungen aufweisen und somit oberseitig keine weiteren Anschlussmöglichkeiten bieten und überdies oberseitig beispielsweise durch eine Lackschicht isoliert sein können.

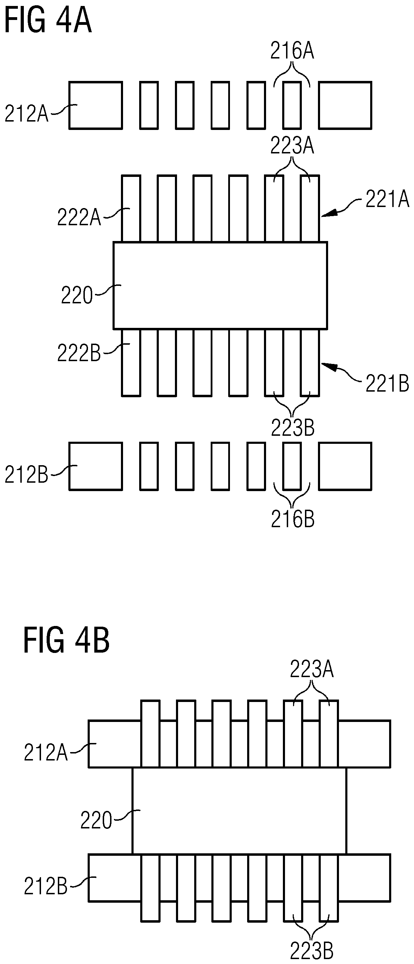

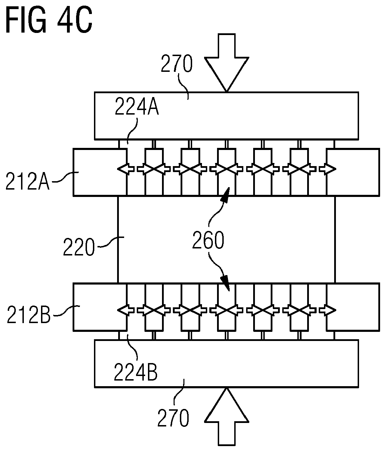

Eine besondere Zapfen- und Aussparungsform ist im Ausführungsbeispiel der Fig. 4 gezeigt. Anders als in den Fig. 1 bis 3, in denen die Aussparungen als Sacköffnungen dargestellt wurden, welche die Zapfen entlang deren gesamter Länge umschließen, sind die Zapfen 223A, 223B in Fig. 4 länger als die Aussparungen 216A, 216B, welche ihrerseits als durchgehende Öffnungen ausgebildet sind. Von den sich daraus ergebenden konstruktiven Besonderheiten abgesehen ist das in Fig. 4 dargestellte Beispiel mit den sonstigen in Zusammenhang mit Fig. 1 bis 3 beschriebenen Ausgestaltungen ohne weiteres kombinierbar.

Ein in Fig. 4A beispielhaft dargestellter Halbleiter 220 weist an zwei gegenüberliegenden Seiten jeweils einen Kontakt 221A, 221B auf, bei dem aus jeweiligen Flächen 222A, 222B Zapfen bzw. Pillars 223A, 223B herausragen. Leiter 212A, 212B weisen passende Öffnungen 216A, 216B zur Aufnahme der Zapfen bzw. Pillars 223A, 223B auf und sind mit diesen kaltverschweißbar. Dabei sind die Zapfen, wie in Fig. 4B gezeigt, etwas länger als die Ausdehnung der Leiter 212A, 212B in Richtung der Öffnungen, weswegen die Zapfen 223A, 223B aus den durchgehenden Öffnungen 216A, 216B herausragen, nachdem sie vollständig bzw. bis zur vorgesehenen Montageposition in die Öffnungen eingeführt wurden. Die Zapfen 223A und 223B können sich dabei noch vorteilhaft auf einer metallischen Bufferschicht (in Fig. 4 nicht dargestellt) befinden, welche wiederrum auf dem Halbleiter 220 aufgebracht wird. Die Bufferschicht hat dabei die Aufgabe, bei dem im folgenden beschriebenen Fügeprozess eine bessere Druck- bzw. Kraftverteilung zu bewirken und somit das Risiko einer Beschädigung des Halbleiters zu reduzieren.

Die Kaltverschweißung 260 wird erreicht, indem wie in Fig. 4C dargestellt flächig Druck auf die Zapfenenden ausgeübt wird, beispielsweise durch die Backen 270 einer Presse (angedeutet durch die großen Pfeile in vertikaler Richtung), und die Zapfen dabei in den Öffnungen verpresst und dabei kaltverschweißt werden (Formschluss und Kaltverschweißung angedeutet durch die kleinen Pfeile in horizontaler Richtung). Optional kann dabei der Überstand der Zapfen so gewählt werden, dass auch nach der Verpressung der Zapfen in den Öffnungen ein Teil der Zapfen übersteht und diese zu einer Stülpung bzw. einer Art Nietkopf 224A, 224B verformt werden, die unterseitig flächig an den Leitern 212A, 212B anliegen und damit zusätzliche Kontaktfläche liefern und den Übergangswiderstand zwischen Halbleiter 220 und Leitern 212 weiter verringern. Außerdem wird die Verbindung zwischen Halbleiter 220 und Leitern 212 auf diese Weise zusätzlich mechanisch gegen Lösen gesichert.

Einer der Leiter 212A, 212B oder beide gemeinsam übernehmen in diesem Fall die Funktion des Trägers für den Halbleiter 220 oder sind mit diesem verbunden, beispielsweise in einer tiefer und parallel zur Abbildungsebene liegenden Ebene. Insbesondere kann es sich bei den Leitern 212A, 212B um sogenannte Leadframes handeln. In alternativen Ausgestaltungen dieses Ausführungsbeispiels weist der Halbleiter nur auf einer Seite, beispielsweise auf der Oberseite, Zapfen bzw. Pillars auf, die in Durchgangsöffnungen kaltverschweißt werden, und kann auf der anderen Seite mit einer bekannten Kontaktierungstechnik oder mit der im Zusammenhang mit Fig. 1 bis 3 beschriebenen Technik kontaktiert werden oder insgesamt nur einseitig kontaktiert werden.

Es sei darauf hingewiesen, dass in den Darstellungen und im vorstehenden Text die Begriffe bzw. die räumliche Orientierung "oben", "unten", "horizontal", "vertikal" bezogen auf die fachübliche Darstellung mit dem Träger (beispielsweise der Leiterplatte) unten und den Bauelementen darauf angeordnet gewählt wurde, d.h. der Träger ist "unten" und definiert insoweit eine "Unterseite" des Bauelements und entsprechend eine "Oberseite". Dies ist nicht einschränkend zu verstehen, da natürlich der Einbau des fertig bestückten Trägers in einer beliebigen Orientierung in ein Gerät erfolgen kann und auch das Gerät selbst in mehreren Orientierungen betrieben werden kann. Die Begriffe "dem Träger zugewandte Seite/Fläche des Bauelements/Verbinders" entsprechend unten und "die zu der dem Träger zugewandten Seite/Fläche parallele Seite/Fläche des Bauelements/Verbinders" entsprechend oben beschreiben dies besser und wurden hier lediglich der besseren Lesbarkeit zuliebe nicht oder jedenfalls nicht durchgängig verwendet.

Es sei ferner darauf hingewiesen, dass hier nur ausgewählte Ausführungsbeispiele beschrieben wurden, die sich die vorliegende Erfindung zunutze machen, die wie bereits erläutert ein Fügepaar bestehend aus einem Zapfen und einer Aussparung und dessen Herstellung betrifft. Ausgehend davon ist der Fachmann nunmehr durch die nachfolgenden Patentansprüche in Zusammenschau mit den detailliert beschriebenen Ausführungsbeispielen in die Lage versetzt, beliebige weitere die Erfindung nutzende Abwandlungen, insbesondere Bauelemente und Verbinder, anzugeben.

Schließlich sei darauf hingewiesen, dass die Ausführungsbeispiele der vorliegenden Erfindung auf Leistungshalbleiter Bezug nehmen, weil dort die zuverlässige, möglichst großflächige, möglichst chipnahe und deswegen möglichst ohne Zuführung von Wärme durchgeführte Kontaktierung von besonderer Bedeutung ist. Die Erfindung ist aber natürlich nicht auf Leistungshalbleiter beschränkt, sondern im Zusammenhang mit allen auf Schaltungsträgern montierbaren Bauelementen, aktiv oder passiv, einsetzbar.

## Patentansprüche

1. Auf einen Schaltungsträger (10, 212) aufbringbares Schaltungselement (20, 120, 150, 220) mit mindestens einem elektrischen Kontakt (21, 121, 151, 221), wobei der Kontakt einen flächigen Abschnitt (22, 222) aufweist, auf dem ein Zapfen (23, 223) oder eine Aussparung ausgebildet ist und wobei der Zapfen oder die Aussparung zur Verbindung mit einer Aussparung (32, 216) oder einem Zapfen (34) eines flächigen Abschnitts (31) eines elektrischen Kontakts (12, 212) eines anderen Elements (30) oder des Schaltungsträgers (10) ausgebildet ist und im verbundenen Zustand mit dieser Aussparung oder diesem Zapfen eine kaltgeschweißte Verbindung (60, 260) bildet.

2. Schaltungselement nach Anspruch 1, bei dem die Aussparung zwischen zumindest einem auf dem jeweiligen flächigen Abschnitt angeordneten weiteren, vorzugsweise hohl ausgebildeten Zapfen (35) und mindestens einem weiteren auf dem jeweiligen flächigen Abschnitt angeordneten Element ausgebildet ist.

3. Schaltungselement nach einem der vorhergehenden Ansprüche, dessen Kontakt mehrere Zapfen und/oder Aussparungen auf dem flächigen Abschnitt aufweist.

4. Schaltungselement nach Anspruch 3, bei dem die Zapfen und/oder Aussparungen in einem Raster angeordnet sind, vorzugsweise in einem quadratischen Raster.

5. Schaltungselement (120, 150) nach einem der vorhergehenden Ansprüche, das einen weiteren elektrischen Kontakt aufweist, wobei der weitere Kontakt einen flächigen Abschnitt aufweist, der im Wesentlichen parallel zum flächigen Abschnitt des Kontakts orientiert ist und wobei der flächige Abschnitt des Kontakts nur Zapfen und der flächige Abschnitt des weiteren Kontakts nur Aussparungen aufweist.

6. Elektrischer Verbinder (30, 50, 112, 130, 140, 212) mit mindestens einem elektrischen Kontakt, wobei der Kontakt einen flächigen Abschnitt aufweist, auf dem ein Zapfen (34) oder eine Aussparung (32) ausgebildet ist und wobei der Zapfen oder die Aussparung zur Verbindung mit einer Aussparung oder einem Zapfen (23, 223) eines flächigen Abschnitts eines elektrischen Kontakts eines weiteren elektrischen Verbinders oder eines Schaltungselements nach einem der vorhergehenden Ansprüche ausgebildet ist und im verbundenen Zustand mit dieser Aussparung oder diesem Zapfen eine kaltgeschweißte Verbindung (60, 260) bildet.

7. Elektrischer Verbinder nach Anspruch 6, bei dem die Aussparung zwischen zumindest einem auf dem jeweiligen flächigen Abschnitt angeordneten weiteren, vorzugsweise hohl ausgebildeten Zapfen (35) und mindestens einem weiteren auf dem jeweiligen flächigen Abschnitt angeordneten Element ausgebildet ist.

8. Elektrischer Verbinder nach einem der Ansprüche 6 bis 8, dessen Kontakt mehrere Zapfen und/oder Aussparungen auf dem flächigen Abschnitt aufweist.

9. Elektrischer Verbinder nach Anspruch 8, bei dem die Zapfen und/oder Aussparungen in einem Raster angeordnet sind, vorzugsweise in einem quadratischen Raster.

10. Elektrischer Verbinder nach einem der Ansprüche 6 bis 9, das einen weiteren elektrischen Kontakt aufweist, wobei der weitere Kontakt einen flächigen Abschnitt aufweist, der im Wesentlichen parallel zum flächigen Abschnitt des Kontakts orientiert ist und wobei der flächige Abschnitt des Kontakts nur Zapfen (34) und der flächige Abschnitt des weiteren Kontakts nur Aussparungen (32) aufweist.

11. Verfahren zum Herstellen einer elektrischen Verbindung zwischen einem auf einem Schaltungsträger (10) anbringbaren Schaltungselement (20, 120, 150, 220) und einem weiteren Element (30, 50, 112, 130, 140, 212), mit folgenden Schritten:
- Bereitstellen jeweils eines elektrischen Kontakts mit einem flächigen Abschnitt an dem Schaltungselement und an dem weiteren Element;
- Bereitstellen eines Zapfens aus leitfähigem Material auf dem flächigen Abschnitt eines der Kontakte sowie Bereitstellen einer korrespondierenden Aussparung aus leitfähigem Material auf dem flächigen Abschnitt des anderen Kontaktes, wobei das leitfähige Material des Zapfens und das leitfähige Material der Aussparung so gewählt werden, dass diese kaltverschweißbar sind; und
- Einführen des Zapfens in die Aussparung und dabei Kaltverschweißen von Zapfens und Aussparung.

12. Verfahren nach Anspruch 11, bei dem die Aussparung zwischen zumindest einem auf dem jeweiligen flächigen Abschnitt angeordneten weiteren, vorzugsweise hohl ausgebildeten Zapfen (35) und mindestens einem weiteren auf dem jeweiligen flächigen Abschnitt angeordneten Element gebildet wird.

13. Verfahren nach Anspruch 11, bei dem
- die Aussparung als Durchgangsbohrung (216) bereitgestellt wird;
- der Zapfen (223) so gebildet wird, dass er nach dem vollständigen Einführen in die Durchgangsbohrung auf der anderen Seite der Durchgangsbohrung herausragt; und
- die Kaltverschweißung bewirkt wird, indem der Zapfen zumindest teilweise in der Durchgangsbohrung verpresst wird.

14. Verfahren nach einem der Ansprüche 11 bis 13, bei dem mehrere Zapfen und korrespondierende Aussparungen auf den flächigen Abschnitten der Kontakte bereitgestellt und im Wesentlichen gleichzeitig gefügt werden.

15. Verfahren nach einem der Ansprüche 11 bis 14, bei dem die Zapfen und korrespondierenden Aussparungen in einem Raster angeordnet werden, vorzugsweise in einem quadratischen Raster.
